# EUROPEAN PATENT APPLICATION

(11) **EP 4 700 827 A1**
(43) Date of publication of application: **25.02.2026**
(21) Application number: 24195214.2
(22) Date of filing: 19.08.2024
(51) Int. Cl.: H01L 23/053, H01L 23/057, H01L 23/373, H01L 23/498, H01L 23/00, H01L 25/07

(54) **POWER SEMICONDUCTOR MODULE ARRANGEMENT**

(71) Applicant: Infineon Technologies AG, 85579 Neubiberg (DE)
(72) Inventor: ARENS, Andre, 59602 Rüthen (DE); ROSTEK, Johannes, 59494 Soest (DE); GROOVE, Andreas, 59602 Rüthen (DE)
(74) Representative: Westphal, Mussgnug & Partner, Patentanwälte mbB

(57) **Abstract**

A semiconductor module arrangement comprises a housing, a substrate arranged in or forming a bottom of the housing, a bus bar comprising a first end, and a second end opposite the first end, wherein the first end is arranged inside the housing, and the second end extends to the outside of the housing, and at least one connecting element mechanically and electrically coupled to a top surface of the substrate, wherein the first end of the bus bar is arranged distant from the substrate in a vertical direction, wherein the vertical direction is a direction perpendicular to the top surface of the substrate, and the first end of the bus bar is electrically coupled to at least one of the at least one connecting element by means of one or more electrical connections.

## Description

### TECHNICAL FIELD

The instant disclosure relates to a power semiconductor module arrangement, in particular to a power semiconductor module arrangement comprising bus bars.

### BACKGROUND

Power semiconductor module arrangements often include at least one substrate (e.g., ceramic substrate) arranged in a housing. A semiconductor arrangement including a plurality of controllable semiconductor elements (e.g., IGBTs, diodes, or other semiconductor devices) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate. The controllable semiconductor devices are usually mounted to the substrate by soldering or sintering techniques.

Electrical lines or electrical connections are used to connect different semiconductor devices of the power semiconductor arrangement with each other. Further, terminal elements and bus bars or conductor rails are provided to contact the semiconductor arrangement from outside of the housing. Bus bars or conductor rails are usually electrically coupled to the first metallization layer with a first end. A second end of the terminal elements, bus bars and conductor rails protrudes out of the housing. The first end of a bus bar or conductor rail, however, may not be mechanically coupled to the first metallization layer. The first end may extend into a casting compound filling an interior of the housing, but may be arranged at a certain distance from the substrate. An electrical connection between the bus bar and the substrate is provided by means of electrical connections such as, e.g., bonding wires. During operation of the semiconductor module, the current flowing through the electrical connections that are used to electrically couple the bus bar to the substrate may cause the electrical connections to heat. A heat distribution between the different electrical connections, however, may not be even such that some electrical connections heat significantly more than others. This may result in the electrical connection between the bus bar and the substrate to be adversely affected.

There is a need for a semiconductor module arrangement which provides a reliable electrical connection between a bus bar and a substrate of the semiconductor module.

### SUMMARY

A power semiconductor module arrangement includes a housing, a substrate arranged in or forming a bottom of the housing, a bus bar including a first end, and a second end opposite the first end, wherein the first end is arranged inside the housing, and the second end extends to the outside of the housing, and at least one connecting element mechanically and electrically coupled to a top surface of the substrate, wherein the first end of the bus bar is arranged distant from the substrate in a vertical direction, wherein the vertical direction is a direction perpendicular to the top surface of the substrate, and the first end of the bus bar is electrically coupled to at least one of the at least one connecting element by means of one or more electrical connections.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a semiconductor module arrangement.
Figure 2 schematically illustrates a top view of a semiconductor module arrangement.
Figure 3 schematically illustrates a three-dimensional view of a section of a semiconductor module arrangement.
Figure 4 schematically illustrates a three-dimensional view of a section of a semiconductor module arrangement according to embodiments of the disclosure.
Figure 5 is a cross-sectional view of a semiconductor module arrangement according to embodiments of the disclosure.
Figure 6 schematically illustrates a three-dimensional view of a section of a semiconductor module arrangement according to further embodiments of the disclosure.
Figure 7 schematically illustrates a three-dimensional view of a connecting element according to embodiments of the disclosure.
Figure 8 schematically illustrates a bottom view of a connecting element according to further embodiments of the disclosure.
Figure 9 schematically illustrates a three-dimensional view of the connecting element of Figure 8.
Figure 10 schematically illustrates a front view of a connecting element according to embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

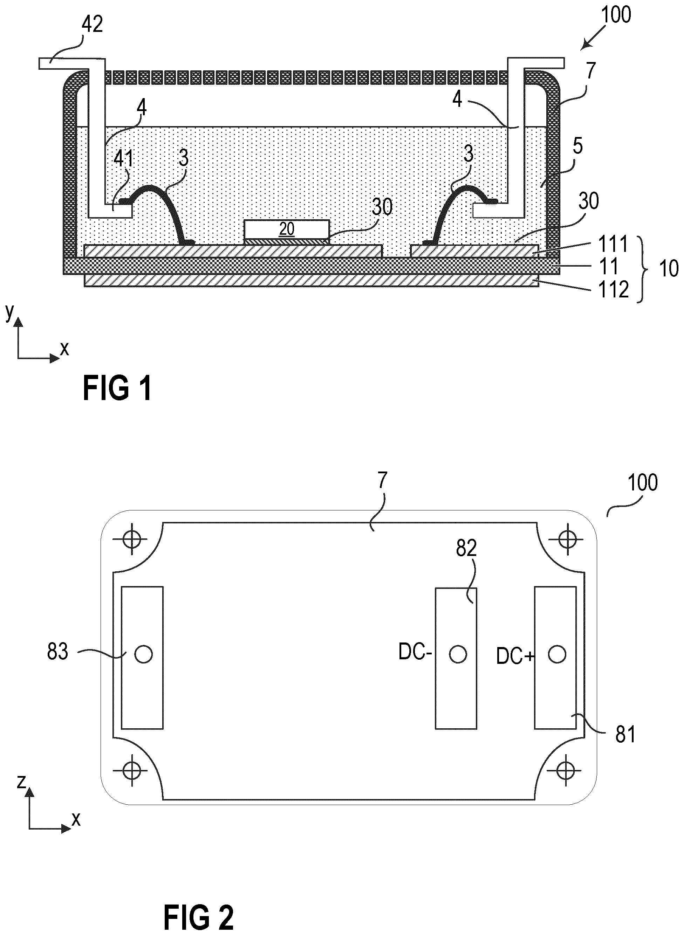

Referring to Figure 1, a cross-sectional view of a semiconductor module arrangement 100 is schematically illustrated. The semiconductor module arrangement 100 includes a housing 7 and a substrate 10. The substrate 10 includes a dielectric insulation layer 11, a (structured) first metallization layer 111 attached to the dielectric insulation layer 11, and a second (structured) metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the semiconductor module arrangement 100. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a base or base surface of the housing 7, while the housing 7 itself solely comprises sidewalls and a cover. This is, however, only an example. It is also possible that the housing 7 further comprises a base surface and the substrate 10 be arranged on the base surface inside the housing 7. According to another example, the substrate 10 may be mounted on a base plate (not illustrated). In some semiconductor module arrangements 100, more than one substrate 10 is arranged on the base surface of a housing 7 or on a single base plate (not illustrated). A base plate may form a base surface of the housing 7, for example.

One or more semiconductor bodies 20 may be arranged on the at least one substrate 10 (e.g., on the first metallization layer 111). Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable semiconductor element.

The one or more semiconductor bodies 20 may form a semiconductor arrangement on the substrate 10. In Figure 1, only one semiconductor body 20 is exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such a recess is schematically illustrated in Figure 1. The first metallization layer 111 in this example includes two different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using, e.g., bonding wires 3. Electrical connections 3 may also include bonding ribbons, connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example. According to other examples, it is also possible that the second metallization layer 112 is a structured layer. It is further possible to omit the second metallization layer 112 altogether.

The semiconductor module arrangement 100 illustrated in Figure 1 further includes a plurality of conductor rails or bus bars 4 (in the following only referred to as bus bars). The bus bars 4 are electrically connected to the first metallization layer 111 and provide an electrical connection between the inside and the outside of the housing 7. The bus bars 4 comprise a first end 41 and a second end 42 opposite the first end 41, wherein the first end 41 is arranged inside the housing 7, and the second end 42 extends to the outside of the housing 7. The first end 41 is electrically coupled to the first metallization layer 111. The first end 41, however, does not directly contact the substrate 10. The first end 41 is arranged distant from the substrate 10 in a vertical direction y. An electrical connection between the first end 41 of the bus bar 4 and the substrate 10 is implemented by means of electrical connections 3 such as, e.g., bonding wires or bonding ribbons. The bus bars 4 may be electrically contacted from the outside at their second end 42.

In the semiconductor module arrangement 100 illustrated in Figure 1, a middle section of the bus bars 4 (middle section arranged between first end 41 and second end 42) extends through the inside of the housing 7 in a vertical direction y. The vertical direction y is a direction perpendicular to a top surface of the substrate 10, wherein the top surface of the substrate 10 is a surface on which the at least one semiconductor body 20 is mounted. Instead of in the vertical direction y, the middle section of a bus bar 4 which is arranged inside the housing 7 can also extend diagonally, for example. According another example, the middle section of a bus bar 4 arranged inside the housing 7 can have different sub-sections, wherein each of the different sub-sections may extend in a vertical, diagonal or horizontal direction. The second ends 42 of the bus bars 4 that are arranged outside of the housing 7 may extend in a first horizontal direction x which is parallel to the top surface of the substrate 10, as is exemplarily illustrated in Figure 1. In this way, for many applications it may be easier to electrically contact the second ends 42. The first ends 41 of the bus bars 4 may also extend in the first horizontal direction x and in parallel to the top surface of the substrate 10. In this way, a flat surface (often also referred to as bonding balcony) is provided that the electrical connections 3 may be attached to. The bus bars 4 illustrated in Figure 1 are only examples. Bus bars 4 generally may be implemented in any other way and may be arranged anywhere within the housing 7.

The power semiconductor module arrangement 100 may further comprise a plurality of terminal elements (not specifically illustrated in Figure 1). Terminal elements are generally configured to conduct control signals to and from the substrate 10. Control signals usually comprise electrical signals of 15V or less and are configured to control the function of the different semiconductor bodies 20. Control signals, however, may also comprise electrical signals of more than 15V. It is further necessary to provide supply voltages to the power semiconductor module arrangement 100. The power semiconductor module arrangement 100 may switch from an off state (non-working state) to an on state (working state), for example, when a supply voltage is provided. Supply voltages are generally high voltages of more than 100V, more than 300V, more than 600V and even up to several thousands of volts. The supply voltage can be between 500V and 10kV, or between 600V and 6.5kV, for example. The bus bars 4 are configured to provide such a supply voltage. Bus bars 4 may also be used to provide control signals of (significantly) more than 15V, for example. The currents flowing through the bus bars 4 are generally also significantly higher than currents flowing through terminal elements.

Terminal elements that are used to conduct control signals to and from the substrate 10 are often implemented as simple pins having a comparably small cross-sectional area. The bus bars 4, on the other hand, in order to be able to provide the significantly higher supply voltages and, in particular, the resulting high currents, have a larger cross-sectional area as compared to the terminal elements. According to one example, each bus bar 4 of the plurality of bus bars 4, therefore, comprises or is formed by a metal sheet.

The semiconductor module 100 generally further includes a casting compound 5. The casting compound 5 may consist of or include a silicone gel, a silicone, polyurethane, epoxy, or polyacrylate based isolation material, or may be a rigid molding compound, for example. The casting compound 5 may at least partly fill the interior of the housing 7, thereby covering the components and electrical connections that are arranged on the substrate 10. The bus bars 4 may be partly embedded in the casting compound 5. For example, at least the first ends 41 of the bus bars 4 may be covered by the casting compound 5. The middle section of a bus bar 4 may be at least partly covered by the casting compound 5. At least the second ends 42 of the bus bars 4, however, are not covered by the casting compound 5 and protrude from the casting compound 5 through the housing 7 to the outside of the housing 7. The casting compound 5 is configured to protect the components and electrical connections inside the semiconductor module 100, in particular inside the housing 7, from certain environmental conditions and mechanical damage.

As has been mentioned above, the semiconductor module arrangement 100 comprises a semiconductor arrangement arranged on the substrate 10, the semiconductor arrangement comprising at least two semiconductor bodies 20. The at least two semiconductor bodies 20 may be arranged in a half-bridge configuration, for example. Any other configurations, however, are also possible. A half-bridge arrangement is generally configured to convert a DC voltage provided at an input 81, 82 of the half-bridge arrangement into an AC voltage and provided at an output 83 of the half-bridge arrangement. The AC voltage may be provided to, e.g., a load, that is coupled to the output 83 of the half-bridge arrangement. The semiconductor arrangement may be coupled between a first supply node 81 which is configured to be operatively coupled to a first electrical potential DC+ and a second supply node 82 which is configured to be operatively coupled to a second electrical potential DC-. The first electrical potential DC+ may be a positive potential and the second electrical potential DC- may be a negative potential to supply a DC voltage via the first and second supply nodes 81, 82. The first and second supply nodes 81, 82 may form the input of a half-bridge arrangement. Generally, however, the different nodes and, therefore, the different bus bars 4 may be electrically coupled to any other electrical potential instead.

One or more different bus bars 4 may be provided in order to electrically contact a semiconductor arrangement. According to one example, one bus bar 4 may be provided to form or to contact the first supply node 81, one bus bar 4 may be provided to form or to contact the second supply node 82, and one bus bar 4 may be provided to form or to contact the output node 83. For example, the second end 42 of a first bus bar 4 may form or contact the first supply node 81, the second end 42 of a second bus bar 4 may form or contact the second supply node 82, and the second end of a third bus bar 4 may form or contact the output node 83. The different bus bars 4 are electrically coupled to each other by means of the semiconductor arrangement and/or the first metallization layer 111 of the substrate 10.

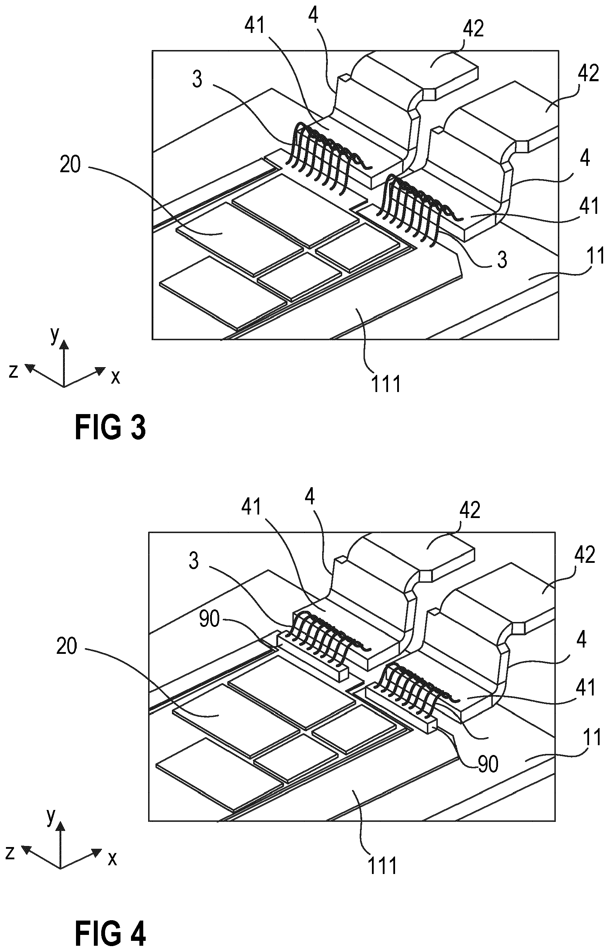

Figure 2 schematically illustrates a top view of a power semiconductor module arrangement 100 according to one example. In this top view, the housing 7 (i.e., the lid or cover of the housing 7) conceals any components arranged inside the housing 7. Therefore, the substrate 10 and any components arranged thereon are not visible in the top view of Figure 2. Figure 2, however, illustrates the second ends 42 of a plurality of bus bars 4, which protrude to the outside of the housing 7 and which form or contact the first and second supply node 81, 82 and output node 83, respectively. Figure 3 schematically illustrates a three-dimensional view of a semiconductor module similar to the semiconductor module of Figure 1. In this three-dimensional view, an exemplary implementation of a plurality of bus bars 4 is schematically illustrated.

As has been described above, the first ends 41 of the bus bars 4 usually extend into a casting compound 5 filling an interior of the housing 7, but are arranged at a certain distance from the substrate 10. This is, because directly mounting the first ends 41 of the bus bars 4 to the first metallization layer 111 is generally cumbersome and requires a significant amount of space which is usually not available in a semiconductor module. Instead of directly coupling the bus bars 4 to the substrate 10, an electrical connection between the bus bars 4 and the substrate 10 is provided by means of electrical connections 3 such as, e.g., bonding wires or bonding ribbons. During operation of the semiconductor module, the (usually comparably high) currents flowing through the electrical connections 3 that are used to electrically connect the bus bars 4 to the substrate 10 may cause the electrical connections 3 to heat. This is, because the cross-sectional area of each electrical connection 3 is small as compared to the cross-sectional area of the bus bar 4. A heat distribution between the different electrical connections 3, however, may not be even such that some electrical connections 3 electrically coupling a bus bar 4 to the substrate 10 heat significantly more than others. This may result in the overall electrical connection between the bus bar 4 and the substrate 10 to be adversely affected.

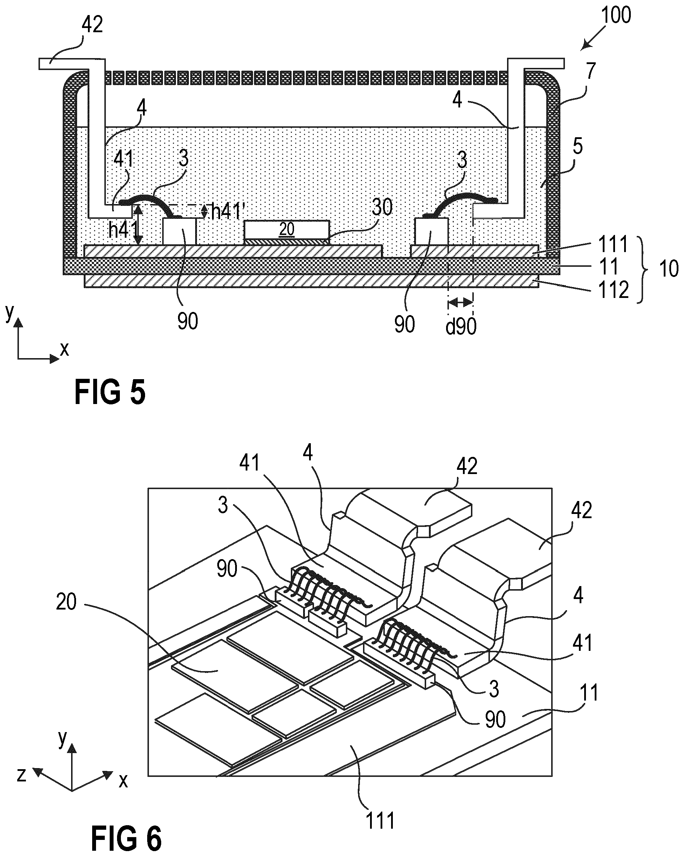

In order to overcome these disadvantages, a semiconductor module arrangement according to embodiments of the disclosure comprises a housing 7, a substrate 10 arranged in or forming a bottom of the housing 7, a bus bar 4 comprising a first end 41, and a second end 42 opposite the first end 41, wherein the first end 41 is arranged inside the housing 7, and the second end 42 extends to the outside of the housing 7, and at least one connecting element 90 mechanically and electrically coupled to a top surface of the substrate 10. The first end 41 of the bus bar 4 is arranged distant from the substrate 10 in a vertical direction y, wherein the vertical direction y is a direction perpendicular to the top surface of the substrate 10. The first end 41 of the bus bar 4 is electrically coupled to at least one of the at least one connecting element 90 by means of a plurality of electrical connections 3. This is exemplarily illustrated in the three-dimensional view of Figure 4 and in the cross-sectional view of Figure 5.

That is, each electrical connection 3 of the plurality of electrical connections 3 is mechanically and electrically coupled to one connecting element 90 with a first end, and to the first end 41 of the bus bar 4 with a second end opposite the first end. In the arrangement illustrated in Figures 1 and 3, the electrical connections 3 are comparably long, That is, because the first end 41 of the bus bar 4 is arranged vertically above the first metallization layer 111, and the electrical connections 3 extend all the way from the first end 41 of the bus bar 4 to the first metallization layer 111. In the semiconductor arrangements illustrated in Figures 4 and 5, a length of each electrical connection 3 of the plurality of electrical connections 3 is shorter as compared to the arrangements of Figures 1 and 3. This is, because the at least one connecting element 90 provides an elevation on the first metallization layer 111, to which the electrical connections 3 may be attached. This is clearly visible in the arrangement illustrated in Figure 5, as compared to the arrangement illustrated in Figure 1. Each connecting element 90 of the at least one connecting element 90 provides a bonding surface for one or more bonding wires or bonding ribbons. That is, each connecting element 90 of the at least one connecting element 90 is arranged on the first metallization layer 111 of the substrate 10 in a position where the electrical connections 3 would be attached to the first metallization layer 111 in arrangements without connecting elements 90 (see, e.g., Figure 1). That is, a distance d90 between a connecting element 90 and a respective bus bar 4 to which the connecting element 90 is electrically coupled by means of the one or more electrical connections 3 in a horizontal direction x is comparably short. For example, a distance d90 between a connecting element 90 and a respective bus bar 4 to which the connecting element 90 is electrically coupled by means of the one or more electrical connections 3 in a horizontal direction x may be between 0 and 10 mm (millimeters), or between 0 and 5mm.

A current flowing from the bus bar 4 through the electrical connections 3 and into the connecting element 90 spreads symmetrically in the connecting element 90. Due to the comparably short length of the electrical connections 3, the heat generated in the electrical connections 3 is significantly reduced. Even further, due to the comparably short length of the electrical connections 3 and the symmetric spreading of the current in the connecting element 90, the temperature distribution between the different electrical connections 3 is more symmetric as compared to conventional arrangements without any connecting elements 90. That is, all electrical connections 3 of a plurality of electrical connections 3 heat essentially equally.

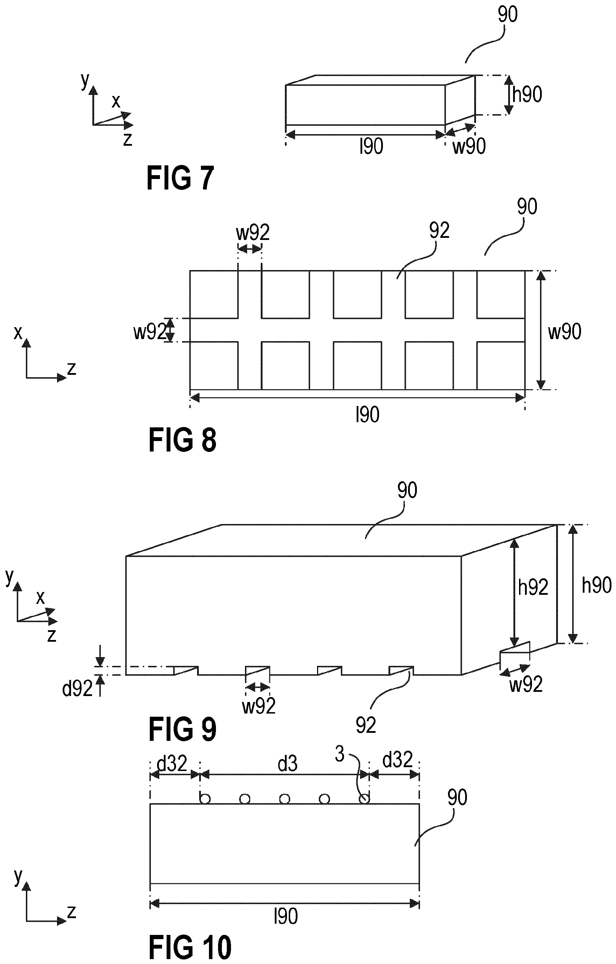

Each connecting element 90 may be a comparably simple element. For example, each connecting element 90 of the at least one connecting element 90 may have the shape of a right rectangular prism. This is schematically illustrated in Figure 7. As is illustrated in Figure 7, a connecting element 90 may have a length 190 in a second horizontal direction z that is significantly larger than its width w90 in the first horizontal direction x, and its height h90 in the vertical direction y. For example, the length l90 may be at least twice, at least three time, or at least five times its width w90, and at least twice, at least three time, or at least five times its height h90. The width w90 and the height h90 of a connecting element 90 may be identical or may differ from each other.

The height h90 of a connecting element 90 generally depends on a distance h41 between a surface of the first end 41 of the bus bar 4 facing away from the substrate 10 and the substrate 10. For example, a height h90 of each connecting element 90 of the at least one connecting element 90 in the vertical direction y may be at least half of the distance h41 between a surface of the first end 41 facing away from the substrate 10 and the substrate 10. In this way, a length of the electrical connections 3 may already be significantly reduced. A shorter height h90 is generally also possible, the effects, however, are more significant if a height h90 of the respective connecting element 90 is greater. On the other hand, a height h90 of each connecting element 90 of the at least one connecting element 90 in the vertical direction y may be equal to or less than a distance h41 between a surface of the first end 41 facing away from the substrate 10 and the substrate 10. If the height h90 of each connecting element 90 of the at least one connecting element 90 in the vertical direction y is equal to the distance h41 between the surface of the first end 41 facing away from the substrate 10 and the substrate 10, the length of each electrical connection 3 may be shortest. This, however, may require a certain amount of material to form the connecting element 90.

A distance h41 between a surface of the first end 41 of the bus bar 4 facing away from the substrate 10 and the substrate 10 is generally comparably short. The first end 41 of a bus bar 4 is generally arranged comparably close to the substrate 10. That is, because the first end 41 and the electrical connections 3 formed thereon in order to connect it to the substrate 10 are usually covered by the casting compound 5. In this way, the casting compound 5 protects the first end 41 and the electrical connections 3 formed thereon from certain environmental conditions and mechanical damage. The material that is used to form the casting compound 5, however, is comparably expensive. Therefore, it is generally desirable to keep the casting compound 5 as thin as possible in the vertical direction y. According to embodiments of the disclosure, the distance h41 between a surface of the first end 41 of the bus bar 4 facing away from the substrate 10 and the substrate 10 may be between 1.5 and 5mm. According to some embodiments of the disclosure, the distance h41 between a surface of the first end 41 of the bus bar 4 facing away from the substrate 10 and the substrate 10 may be between 2 and 3mm.

The width w90 of a connecting element 90 is generally chosen large enough in order to be able to provide enough space to securely attach one or more electrical connections 3 to the respective connection element 90. For example, the width w90 of a connecting element 90 may be between 2.5 and 6mm, or between 3 and 4mm. The length l90 of a connecting element 90 generally depends on the number of electrical connections 3 that are to be attached to the respective connection element 90. For example, a length l90 of a connecting element 90 may be between 2mm and 20mm. A length l90 of 2mm, for example, may be sufficient if only one electrical connection 3 is to be attached to the respective connecting element 90. A greater length l90 is generally required if more than one electrical connection 3 is to be attached to the respective connecting element 90. As can be seen, the height h90, width w90 and length l90 of a connection element 90 generally depend on different factors in connection with a specific semiconductor module.

Each connecting element 90 of the at least one connecting element 90 may consist of a metal. According to one example, each connecting element 90 of the at least one connecting element 90 consists of copper, a copper alloy, aluminum, or an aluminum alloy. A connecting element 90 consisting of copper, a copper alloy, aluminum, or an aluminum alloy may be easily manufactured. Further, as has been described above with respect to Figure 1, the first metallization layer 111 often also consists of copper, a copper alloy, aluminum, or an aluminum alloy. That is, according to some examples, the at least one connecting element 90 may consist of the same material as the first metallization layer 111. A connecting element 90 consisting of copper, a copper alloy, aluminum, or an aluminum alloy may also be easily mounted to the first metallization layer 111. For example, each connecting element 90 of the at least one connecting element 90 may be electrically and mechanically connected to the substrate 10 (i.e. the first metallization layer 111) by means of a solder layer. That is, the connecting elements 90 may be placed on the substrate 10 together with any semiconductor bodies 20 or other elements of the substrate 10, and may be soldered to the substrate 10 simultaneously with the semiconductor bodies 20 and any other elements in one and the same soldering step.

In the example illustrated in Figure 4, a first bus bar 4 is electrically coupled to a first connecting element 90 by means of a first plurality of electrical connections 3, and a second bus bar 4 is electrically coupled to a second connecting element 90 by means of a second plurality of electrical connections 3. That is, one connecting element 90 is provided for each of the bus bars 4. This, however, is only an example. As is exemplarily illustrated in Figure 6, it is also possible that a bus bar 4 is electrically coupled to the substrate 10 by means of a plurality of electrical connections 3, wherein a first subset of the plurality of electrical connections 3 electrically couples the bus bar 4 to a first connecting element 90, and a second subset of the plurality of electrical connections 3 electrically couples the bus bar 4 to a second connecting element 90. That is, in this example, the size of one or more connecting elements 90 (i.e. a length l90 of one or more connecting element 90) may be somewhat smaller as compared to the example illustrated in Figure 4. Smaller connecting elements 90 may be more flexibly used in different semiconductor modules, for example. For example, for some bus bars 4, one somewhat smaller (shorter) connecting element may be sufficient if only few electrical connections 3 are required in order to electrically couple the bus bar 4 to the substrate 10. For other bus bars 4, more electrical connections 3 may be required. In such cases, two or more smaller connecting elements 90 may be used instead of a larger (longer) one. That is, only one kind of somewhat smaller connecting elements 90 may be produced which could then be used in many different applications. As is exemplarily illustrated in Figure 6, it is however also possible that connecting elements 90 of different sizes are combined in one and the same semiconductor module.

According to one embodiment of the disclosure, it is even possible that at least one connecting element 90 of the at least one connecting element 90 is cube-shaped. That is, the length l90 of a connecting element 90 may equal its width w90 and its height h90. In this way, assembling a semiconductor module may be facilitated, as a specific orientation of the connecting element 90 on the substrate 10 is of no specific relevance. In particular, an automatic placement machine or a human operator is not required to make sure that a specific surface of the connecting element 90 faces towards the substrate 10 or towards a specific direction. However, a smaller size (in particular a shorter length l90) of a connecting element 90 may not always be optimal with respect to current distribution. That is, a greater length l90 of a connecting element 90 may be preferred over a shorter length l90, even if this somewhat complicates the assembly process, as it has to be assured that the length l90 of the connecting element 90 extends in the correct direction.

If, on the other hand, a connecting surface of a connecting element 90 (connecting surface defined by its length l90 and its width w90 and facing towards the substrate 10) becomes too large, it may be difficult to solder the connecting element 90 to the substrate 10. Generally, large surfaces are more difficult to solder than smaller ones. Reducing the length l90 of a connecting element 90 and providing two or more smaller (shorter) connecting elements 90 instead of one larger (longer) one is one way in which the soldering surface of each individual connecting element 90 may be reduced. However, as discussed above, a current distribution may not be optimal if the size (i.e. the length l90) of the individual connecting elements 90 is decreased. Therefore, according to another embodiment of the disclosure, a connecting element 90 may comprise at least one trench 92 on a bottom side thereof. The bottom side of a connecting element 90 is a side of the connecting element 90 facing the substrate 10 when the connecting element 90 is attached to the substrate 10. Due to the at least one trench 92, the height h90 of the respective connecting element 90 is locally reduced to a reduced height h92 vertically above each of the at least one trench 92 which, however, does not negatively affect the overall advantages of the connecting element (shorter length of electrical connections 3 and current/heat spreading in connecting element 90). By means of the at least one trench 92, the mounting surface of the connecting element 90 is divided into two or more solder areas of reduced size.

Referring to Figure 8, a connecting element 90 comprising a plurality of trenches 92 on a bottom side thereof is schematically illustrated. In this example, one first trench 92 extends along the length l90 of the connecting element 90, thereby dividing the bottom surface of the connecting element 90 in two equal halves. Further, in the example illustrated in Figure 8, four second trenches 92 extend in parallel to each other and along the width w90 of the connecting element 90. The second trenches 92 extend perpendicular to the first trench 92. In this way, the two halves resulting from the first trench 92 are divided further into even smaller bonding surfaces by means of the second trenches 92. Each of the resulting smaller bonding surfaces may be mechanically and electrically coupled to the first metallization layer 111 by means of an individual solder layer. The different solder layers mechanically and electrically coupling the bonding surfaces of a connecting element 90 to the first metallization layer 111 may be separate and distinct from each other. It is, however, generally possible that one or more of the solder layers spread during the solder process such that they get in direct contact with one or more of the other solder layers. This generally does not negatively affect the general advantages of the connecting element 90 and the trenches 92 formed therein. If one or more trenches 92 are formed in a connecting element 90, the connecting element 90 is less likely to deform during the solder process, even if one or more of the solder layers directly contact each other once the solder process is completed. This is, because the otherwise large bonding surface is divided into a plurality of smaller bonding surface by means of the trenches 92.

Figure 9 schematically illustrates a three-dimensional view of the connecting element 90 of Figure 8. The trenches 92 illustrated in Figures 8 and 9, however, are only examples. Trenches 92 may generally be formed on a bottom side of a connecting element 90 in any other suitable way. In the example illustrated in Figures 8 and 9, one first trench 92 extends in a second horizontal direction z along a length l90 of the connecting element, and a plurality of second trenches 92 extend in a first horizontal direction x along a width w90 of the connecting element 90. In some cases, a single first trench 92 in the first horizontal direction x along a length l90 of the connecting element 90, or a single second trench 92 in the second horizontal direction z along a width w90 of the connecting element 90 may be sufficient. According to other examples, a connecting element 90 may comprise exactly one first trench 92 extending in the first horizontal direction x along a length l90 of the connecting element 90, and exactly one second trench 92 extending in the second horizontal direction z along a width w90 of the connecting element 90. As is illustrated in Figures 8 and 9, a connecting element 90 may also comprise a plurality (two or more) of second trenches 92 extending in the second horizontal direction z along a width w90 of the connecting element 90. It is generally even possible that a connecting element 90 comprises two or more first trenches 92 extending in the first horizontal direction x along a length l90 of the connecting element 90. A width w92 of each trench 92 in a horizontal direction may be between 0.2 and 0.8mm (millimeters), for example. According to one example, a width w92 of each trench 92 is between 0.3 and 0.5mm. A depth d92 of each trench 92 in the vertical direction y may be between 0.2 and 0.8mm (millimeters), for example. According to one example, a depth d92 of each trench 92 is between 0.3 and 0.5mm. That is, the height h90 of the connecting element 90 may be locally decreased by 0.2 to 0.8mm (millimeters), for example. The depth d92 of each trench 92 formed in one and the same connecting element 90 may be equal. Depending on the number of trenches 92 formed in the connecting element 90, the bottom surface of the connecting element 90 may be divided into two or more (e.g. up to 10 or even up to 20) separate bonding surfaces.

Now referring to Figure 10, a distance d3 between two outermost electrical connections 3 of a plurality of electrical connections 3 electrically coupling the first end 41 of a bus bar 4 to one of the at least one connecting element 90 may be less than a length l90 of the respective connecting element 90 in the same direction. That is, not the entire surface of the connecting element 90 may be used to arrange electrical connections 3 thereon. A distance d32 between an outermost electrical connection 3 of the plurality of electrical connections 3 and the closest end of the connection element 90 may be between 0.1 and 1mm, for example. A greater distance d32 between an outermost electrical connection 3 of the plurality of electrical connections 3 and the closest end of the connection element 90 results in an improved thermal spreading in the connecting element 90.

As mentioned above, the connecting elements 90 according to the various embodiments of the disclosure are easy to manufacture. The connecting elements 90 may be supplied as so-called "tape & reel" and may be arranged on a substrate 10 using standard pick and place processes and equipment. That is, no specific placing equipment is required. Further, the connecting elements 90 may be mechanically and electrically coupled to the substrate 10 by means of standard soldering techniques and during the same soldering steps as other components of the semiconductor module. Therefore, arranging one or more connecting element 90 on a substrate 10 does not require a significant amount of additional assembly time. When using one or more connecting elements 90 to electrically couple a bus bar 4 to the substrate 10, a length of the electrical connections 3 may be significantly reduced as compared to semiconductor modules without connecting elements 90. Due to their shorter length, the resistance of the electrical connections 3 is lower. This results in a more symmetrical distribution of the currents flowing through the electrical connection 3. Excessive heating of one or more electrical connections 3 of a plurality of electrical connections 3 may therefore be avoided.

## Claims

1. A semiconductor module arrangement (100) comprises:
a housing (7);
a substrate (10) arranged in or forming a bottom of the housing (7);
a bus bar (4) comprising a first end (41), and a second end (42) opposite the first end (41), wherein the first end (41) is arranged inside the housing (7), and the second end (42) extends to the outside of the housing (7); and
at least one connecting element (90) mechanically and electrically coupled to a top surface of the substrate (10), wherein
the first end (41) of the bus bar (4) is arranged distant from the substrate (10) in a vertical direction (y), wherein the vertical direction (y) is a direction perpendicular to the top surface of the substrate (10), and
the first end (41) of the bus bar (4) is electrically coupled to at least one of the at least one connecting element (90) by means of one or more electrical connections (3).

2. The semiconductor module arrangement (100) of claim 1, wherein each connecting element (90) of the at least one connecting element (90) has the shape of a right rectangular prism.

3. The semiconductor module arrangement (100) of claim 1, wherein at least one connecting element (90) of the at least one connecting element (90) is cube-shaped.

4. The semiconductor module arrangement (100) of any of claims 1 to 3, wherein the first end (41) of the bus bar (4) extends in a horizontal direction that is perpendicular to the top surface of the substrate (10).

5. The semiconductor module arrangement (100) of claim 4, wherein a height (h90) of each connecting element (90) of the at least one connecting element (90) in the vertical direction (y) is at least half of a distance (h41) between the substrate (10) and a surface of the first end (41) facing away from the substrate (10).

6. The semiconductor module arrangement (100) of claim 4 or 5, wherein a height (h90) of each connecting element (90) of the at least one connecting element (90) in the vertical direction (y) is equal to or less than a distance (h41) between the substrate (10) and a surface of the first end (41) facing away from the substrate (10).

7. The semiconductor module arrangement (100) of any of the preceding claims, wherein each connecting element (90) of the at least one connecting element (90) consists of a metal.

8. The semiconductor module arrangement (100) of claim 7, wherein each connecting element (90) of the at least one connecting element (90) consists of copper, a copper alloy, aluminum, or an aluminum alloy.

9. The semiconductor module arrangement (100) of any of the preceding claims, wherein each connecting element (90) of the at least one connecting element (90) is electrically and mechanically coupled to the substrate (10) by means of at least one solder layer.

10. The semiconductor module arrangement (100) of any of the preceding claims, wherein at least one connecting element (90) of the at least one connecting element (90) comprises at least one trench (92) on a bottom side thereof, the bottom side of a connecting element (90) being a side facing the substrate (10).

11. The semiconductor module arrangement (100) of claim 10, wherein at least one connecting element (90) of the at least one connecting element (90) comprises at least one of:
one or more first trenches (92) extending in a first horizontal direction along a length (l90) of the respective connecting element (90), and
one or more second trenches (92) extending in a second horizontal direction along a width (w90) of the respective connecting element (90).

12. The power semiconductor module arrangement (100) of any of the preceding claims, wherein a distance (d3) between two outermost electrical connections (3) of a plurality of electrical connections (3) electrically coupling the first end (41) of the bus bar (4) to one of the at least one connecting element (90) is less than a length (l90) of the respective connecting element (90) in the same direction.

13. The power semiconductor module arrangement (100) of claim 12, wherein a distance (d32) between an outermost electrical connection (3) of the plurality of electrical connections (3) and a closest end of the respective connection element (90) is between 0.1 and 1mm.

14. The semiconductor module arrangement (100) of any of the preceding claims, wherein each electrical connection (3) of the one or more electrical connections (3) is a bonding wire or a bonding ribbon.

## Amended claims

### Amended claims in accordance with Rule 137(2) EPC.

1. A semiconductor module arrangement (100) comprises:
a housing (7);
a substrate (10) arranged in or forming a bottom of the housing (7), the substrate (10) comprising a dielectric insulation layer (11) and a first metallization layer (111) attached to the dielectric insulation layer (11);
at least one semiconductor body (20) mounted to the first metallization layer (111) of the substrate (10);
a bus bar (4) comprising a first end (41), and a second end (42) opposite the first end (41), wherein the first end (41) is arranged inside the housing (7), and the second end (42) extends to the outside of the housing (7); and
at least one connecting element (90) mechanically and electrically coupled to a top surface of the substrate (10), wherein the top surface of the substrate (10) is a surface on which the at least one semiconductor body (20) is mounted, wherein
the first end (41) of the bus bar (4) is arranged distant from the substrate (10) in a vertical direction (y), wherein the vertical direction (y) is a direction perpendicular to the top surface of the substrate (10), and
the first end (41) of the bus bar (4) is electrically coupled to at least one of the at least one connecting element (90) by means of one or more electrical connections (3).

2. The semiconductor module arrangement (100) of claim 1, wherein each connecting element (90) of the at least one connecting element (90) has the shape of a right rectangular prism.

3. The semiconductor module arrangement (100) of claim 1, wherein at least one connecting element (90) of the at least one connecting element (90) is cube-shaped.

4. The semiconductor module arrangement (100) of any of claims 1 to 3, wherein the first end (41) of the bus bar (4) extends in a horizontal direction that is parallel to the top surface of the substrate (10).

5. The semiconductor module arrangement (100) of claim 4, wherein a height (h90) of each connecting element (90) of the at least one connecting element (90) in the vertical direction (y) is at least half of a distance (h41) between the substrate (10) and a surface of the first end (41) facing away from the substrate (10).

6. The semiconductor module arrangement (100) of claim 4 or 5, wherein a height (h90) of each connecting element (90) of the at least one connecting element (90) in the vertical direction (y) is equal to or less than a distance (h41) between the substrate (10) and a surface of the first end (41) facing away from the substrate (10).

7. The semiconductor module arrangement (100) of any of the preceding claims, wherein each connecting element (90) of the at least one connecting element (90) consists of a metal.

8. The semiconductor module arrangement (100) of claim 7, wherein each connecting element (90) of the at least one connecting element (90) consists of copper, a copper alloy, aluminum, or an aluminum alloy.

9. The semiconductor module arrangement (100) of any of the preceding claims, wherein each connecting element (90) of the at least one connecting element (90) is electrically and mechanically coupled to the substrate (10) by means of at least one solder layer.

10. The semiconductor module arrangement (100) of any of the preceding claims, wherein at least one connecting element (90) of the at least one connecting element (90) comprises at least one trench (92) on a bottom side thereof, the bottom side of a connecting element (90) being a side facing the substrate (10).

11. The semiconductor module arrangement (100) of claim 10, wherein at least one connecting element (90) of the at least one connecting element (90) comprises at least one of:
one or more first trenches (92) extending in a first horizontal direction along a length (190) of the respective connecting element (90), and
one or more second trenches (92) extending in a second horizontal direction along a width (w90) of the respective connecting element (90).

12. The power semiconductor module arrangement (100) of any of the preceding claims, wherein a distance (d3) between two outermost electrical connections (3) of a plurality of electrical connections (3) electrically coupling the first end (41) of the bus bar (4) to one of the at least one connecting element (90) is less than a length (190) of the respective connecting element (90) in the same direction.

13. The power semiconductor module arrangement (100) of claim 12, wherein a distance (d32) between an outermost electrical connection (3) of the plurality of electrical connections (3) and a closest end of the respective connection element (90) is between 0.1 and 1mm.

14. The semiconductor module arrangement (100) of any of the preceding claims, wherein each electrical connection (3) of the one or more electrical connections (3) is a bonding wire or a bonding ribbon.
